(19) Europäisches Patentamt / European Patent Office / Office européen des brevets

(11) **EP 3 243 356 B1**

(12) **FASCICULE DE BREVET EUROPEEN**

(45) Date de publication et mention
de la délivrance du brevet:
**02.12.2020 Bulletin 2020/49**

(21) Numéro de dépôt: **15830823.9**

(22) Date de dépôt: **30.12.2015**

(51) Int Cl.:
**H04W 28/18** *(2009.01)*          **H04W 74/00** *(2009.01)*
**H04W 74/08** *(2009.01)*          **H04W 84/12** *(2009.01)*

(86) Numéro de dépôt international:
**PCT/FR2015/053777**

(87) Numéro de publication internationale:
**WO 2016/110631 (14.07.2016 Gazette 2016/28)**

(54) **SYSTÈME DE TRANSMISSION DE PAQUETS DE DONNÉES SELON UN PROTOCOLE D'ACCÈS MULTIPLE**

SYSTEM ZUR ÜBERTRAGUNG VON DATENPAKETEN GEMÄSS MEHRFACHZUGRIFFSPROTOKOLL

SYSTEM FOR TRANSMITTING DATA PACKETS ACCORDING TO A MULTIPLE ACCESS PROTOCOL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.01.2015 FR 1550110**

(43) Date de publication de la demande:
**15.11.2017 Bulletin 2017/46**

(73) Titulaire: **ORANGE**
**75015 Paris (FR)**

(72) Inventeurs:
• **TORTELIER, Patrick**
  **92110 Clichy (FR)**
• **AZEEM, Muhammad Moazam**
  **75013 Paris (FR)**
• **LE RUYET, Didier**
  **75141 Paris Cedex 3 (FR)**

(56) Documents cités:
**US-A1- 2004 160 943      US-A1- 2007 223 434**
**US-A1- 2010 103 913      US-B1- 7 721 185**

• **ANAS BASALAMAH ET AL: "A Comparison of Packet-Level and Byte-Level Reliable FEC Multicast Protocols for WLANs", GLOBAL TELECOMMUNICATIONS CONFERENCE, 2007. GLOBECOM '07. IEEE, IEEE, PISCATAWAY, NJ, USA, 1 November 2007 (2007-11-01), pages 4702-4707, XP031196820, ISBN: 978-1-4244-1042-2**

**Description**

La présente invention concerne l'émission de paquets de données numériques par plusieurs utilisateurs se partageant un canal de transmission.

Plus particulièrement, elle concerne l'émission de paquets de données en l'absence d'entité centrale coordonnant les instants d'émission des utilisateurs, telle que, par exemple, une entité centrale régissant un accès multiple par répartition dans le temps (« Time-Division Multiple Access », ou TDMA en anglais).

Les protocoles connus d'accès à un canal en l'absence d'entité centrale (qui seront simplement appelés « protocoles d'accès multiple » dans le cadre du présent document) peuvent être classés en deux catégories, selon le degré de coordination entre utilisateurs.

Dans la première catégorie de protocoles, on ne met en place aucune coordination entre utilisateurs ; en particulier, les utilisateurs n'écoutent pas le canal avant transmission pour vérifier que le canal est libre. On essaie d'éviter les collisions entre des paquets émis par des utilisateurs différents en prévoyant que chaque utilisateur émettra des paquets à des instants aléatoires.

Un inconvénient majeur de ces protocoles est l'existence inévitable de collisions entre les paquets émis par des utilisateurs différents, et donc de données perdues, car il existe une probabilité non nulle qu'un paquet soit émis par un utilisateur avant la fin de la transmission d'un paquet par un autre utilisateur.

Une solution à cet inconvénient a été proposée dans l'article de G. Liva, E. Paolini et M. Chiani intitulé « High-Throughput Random Access via Codes on Graphs » (FUNEMS 2010). Elle consiste à introduire, dans un protocole appartenant à ladite première catégorie, un codage correcteur d'effacements permettant la récupération des données perdues dans les collisions. Selon cet article, chaque utilisateur transmet une ou plusieurs répliques de chaque paquet, de sorte que lorsqu'une de ces répliques est reçue sans collision, il est possible de la soustraire de l'analyse des collisions où elle a été impliquée. Un inconvénient de cette solution est qu'elle opère au niveau du signal en sortie du démodulateur (ce sont donc des valeurs analogiques), avec tous les problèmes liés à une estimation imparfaite des gains du canal (sinon les erreurs se propagent au cours des itérations du procédé de correction d'effacements) et à la présence de bruit. Le procédé décrit dans cet article est d'ailleurs mis en œuvre pour des liaisons par satellite géostationnaire, que l'on peut modéliser comme un canal Gaussien caractérisé par un gain et un déphasage constants sur la durée d'un paquet. Cette solution est difficilement envisageable pour des canaux à trajets multiples tels ceux qu'on observe pour le WiFi, c'est-à-dire pour la norme 802.11 de la IEEE (Institute of Electrical and Electronics Engineers).

Dans la seconde catégorie de protocoles, chaque utilisateur écoute le canal, et émet des paquets lorsqu'aucune transmission n'a été détectée. Un exemple représentatif de cette seconde catégorie est donné par la DCF (initiales des mots anglais « Distributed Coordination Function » signifiant « Fonction de Coordination Distribuée ») de la couche MAC (initiales des mots anglais « Media Access Control » signifiant « Contrôle d'Accès au Support ») du WiFi, qui met en œuvre un protocole appelé CSMA/CA (initiales des mots anglais « Carrier Sense Multiple Access/Collision Avoidance » signifiant « Accès Multiple à Détection de Porteuse/Evitement de Collisions »). Dans le CSMA/CA, un premier utilisateur souhaitant émettre des paquets écoute le canal pour savoir si un autre utilisateur est en train d'envoyer des paquets ; si c'est le cas, le premier utilisateur continue d'écouter le canal ; lorsque le premier utilisateur constate pendant un intervalle de temps constant et identique pour tous les utilisateurs que le canal est libre, il patiente encore pendant une certaine durée de contention (« *backoff duration* » en anglais), avant de transmettre un paquet, ladite durée de contention étant une valeur choisie aléatoirement dans un intervalle dit « fenêtre de contention ».

Un premier inconvénient des protocoles de cette seconde catégorie est que des collisions se produisent ici aussi, et cela principalement pour deux raisons :

- à chaque nouvelle période de contention, la fenêtre de contention est décrémentée ; lorsqu'elle devient nulle, le terminal émet ses données sans attendre, avec donc un risque de collision significatif car on ne tient pas compte de l'activité réelle dans le canal ;
- il existe un problème de « nœud caché » (« *hidden node* » en anglais), dans lequel deux terminaux qui ne sont pas en mesure de s'entendre car trop éloignés, transmettent simultanément sur le canal ; toutefois, il existe, pour parer à ce problème de « nœud masqué », un mécanisme appelé RTS/CTS, dans lequel un point d'accès transmet une autorisation de transmettre à l'un des terminaux qui lui a envoyé un RTS (initiales des mots anglais « *Request To Send* » signifiant « Demande de Transmission ») ; le CTS (initiales des mots anglais « *Clear To Send* » signifiant « Acquittement ») envoyé par le point d'accès est reçu par les autres terminaux qui sont dans la couverture de ce point d'accès, de sorte que ces autres terminaux remettent à plus tard leur émission.

Un deuxième inconvénient des protocoles de la seconde catégorie est que le fait d'écouter le canal avant de transmettre des paquets ne parvient à réduire le nombre de collisions subies par un utilisateur qu'au prix d'une réduction non négligeable du temps passé à transmettre : en effet, les utilisateurs passent beaucoup de temps à attendre d'être sûrs que le canal est libre. De ce fait, le débit global de données (« *aggregated throughput* » en anglais), équivalent à l'efficacité spectrale (« *spectral efficiency*» en anglais), d'un tel système de transmission est généralement sous-optimal.

Le document US 2007/0223434 décrit un réseau sans fil, un point d'accès, un dispositif client, un circuit intégré et des procédés permettant de déterminer des paramètres de protocole de transmission sur la base de caractéristiques reçues.

Le document US2010/103913 divulgue un point d'accès qui comprend notamment une unité de décision de la taille minimum de fenêtre de contention, apte à déterminer une taille de fenêtre de contention minimale sur la base du nombre d'antennes de réception et du nombre de stations et une unité de diffusion, apte à diffuser vers les stations la taille minimum de fenêtre de contention déterminée.

La présente invention concerne donc, selon un premier aspect, divers dispositifs. L'invention est définie par les revendications.

Elle concerne ainsi, premièrement, un point d'accès comprenant des moyens pour recevoir des paquets de données émis par au moins un terminal conformément à un protocole d'accès multiple à détection de porteuse, ainsi que des moyens pour transmettre audit terminal au moins la largeur de la fenêtre de contention que ledit terminal doit observer pour l'émission d'un paquet. Ledit point d'accès est remarquable en ce que, lesdits paquets émis étant codés au moyen d'un code correcteur d'effacements, ledit point d'accès comprend en outre des moyens pour décoder les paquets reçus.

Ainsi, la présente invention propose d'appliquer un code correcteur d'effacements aux paquets émis par les différents utilisateurs désirant transmettre des données dans le cadre d'un protocole CSMA/CA, afin de récupérer les paquets effacés suite à des collisions entre plusieurs utilisateurs. En effet, les auteurs de la présente invention ont réalisé (et vérifié, comme décrit en détail ci-dessous) que l'on pouvait ainsi diminuer le nombre de paquets perdus par rapport à une transmission sans codage, et ce, en dépit du fait que la redondance intrinsèque à tout procédé de codage de canal entraîne une augmentation du nombre de paquets transmis, ce qui, a priori, devrait augmenter le nombre de collisions subies par chaque utilisateur.

On notera que, pour les raisons expliquées ci-dessous, le code utilisé sera de préférence un code « Séparable à Distance Maximale » (« *Maximum Distance Separable* », ou MDS, en anglais).

Selon des caractéristiques particulières, ledit point d'accès possède en outre des moyens pour transmettre audit terminal au moins un paramètre dudit code correcteur d'effacements.

Grâce à ces dispositions, le point d'accès fait savoir au terminal quel code d'effacements le terminal doit appliquer aux paquets qu'il émet, dans le cas où ledit paramètre n'a pas été convenu à l'avance (par exemple, sur la base d'une norme).

Selon d'autres caractéristiques particulières, ladite largeur de la fenêtre de contention est fonction au moins de la distance minimale dudit code correcteur d'effacements et du nombre total de terminaux connectés audit point d'accès.

En effet, les auteurs de la présente invention ont réalisé que, dans le cadre de l'invention, on se trouvait confronté aux phénomènes contradictoires suivants.

Si l'on augmente le nombre d'utilisateurs, le débit global de données tend à augmenter, mais le nombre de collisions augmente lui aussi et risque de dépasser la capacité de correction du code ; il faut donc, en compensation, élargir la fenêtre de contention de manière à réduire la probabilité que deux utilisateurs tirent la même valeur aléatoire du délai de contention.

Inversement, si l'on diminue le nombre d'utilisateurs, le nombre de collisions tend à diminuer ; cela permet de rétrécir la fenêtre de contention afin d'augmenter le débit global de données ; mais alors l'augmentation du nombre de paquets émis entraîne une augmentation de la probabilité de collisions, et, là encore, il faudra veiller à ne pas dépasser la capacité de correction du code.

Les auteurs de la présente invention ont réalisé (et vérifié, comme décrit en détail ci-dessous) qu'il était possible, pour tout code correcteur d'effacements donné, d'optimiser la largeur de la fenêtre de contention et la dimension du code en fonction du nombre d'utilisateurs.

Grâce à ces dispositions, on peut avantageusement maximiser le débit global de données (ou l'efficacité spectrale) dans le système de transmission considéré.

L'invention concerne aussi, deuxièmement, un terminal comprenant des moyens pour transmettre à un point d'accès des paquets de données émis conformément à un protocole d'accès multiple à détection de porteuse, ainsi que des moyens pour recevoir de la part dudit point d'accès, et prendre en compte, au moins la largeur de la fenêtre de contention que ledit terminal doit observer pour l'émission d'un paquet. Ledit terminal est remarquable en ce que lesdits paquets émis sont codés au moyen d'un code correcteur d'effacements.

Selon des caractéristiques particulières, ledit terminal comprend en outre des moyens pour recevoir de la part dudit point d'accès, et prendre en compte, au moins un paramètre dudit code correcteur d'effacements.

Les avantages offerts par ce terminal sont essentiellement les mêmes que ceux offerts par le point d'accès succinctement décrit ci-dessus.

Selon un deuxième aspect, l'invention concerne un système de transmission de paquets de données. Ledit système est remarquable en ce qu'il comprend au moins un point d'accès tel que décrit succinctement ci-dessus et au moins un terminal tel que décrit succinctement ci-dessus.

Les avantages offerts par ce système sont essentiellement les mêmes que ceux offerts par les dispositifs succinctement décrits ci-dessus.

On notera qu'il est possible de réaliser ces dispositifs dans le contexte d'instructions logicielles et/ou dans le contexte de circuits électroniques.

L'invention vise également un programme d'ordinateur téléchargeable depuis un réseau de communication et/ou stocké sur un support lisible par ordinateur et/ou exécutable par un microprocesseur. Ce programme d'ordinateur est remarquable en ce qu'il comprend des instructions pour gérer le fonctionnement d'un terminal tel que décrit succinctement ci-dessus ou d'un point d'accès tel que décrit succinctement ci-dessus, lorsqu'il est exécuté sur un ordinateur.

Les avantages offerts par ce programme d'ordinateur sont essentiellement les mêmes que ceux offerts par les dispositifs succinctement décrits ci-dessus.

D'autres aspects et avantages de l'invention apparaîtront à la lecture de la description détaillée ci-dessous de modes de réalisation particuliers, donnés à titre d'exemples non limitatifs. La description se réfère aux figures qui l'accompagnent, dans lesquelles :

- la figure 1 est un schéma des durées mises en jeu classiquement dans le protocole CSMA/CA,
- la figure 2 représente le format des paquets de données, selon un mode de réalisation de l'invention,
- la figure 3 représente la construction de mots de code à partir d'un ensemble de paquets de données, selon un mode de réalisation de l'invention,
- les figures 4 à 7 représentent, en fonction du nombre d'utilisateurs, le débit global moyen en l'absence et en présence de codage, et le taux de paquets effacés et de non-correction après décodage par utilisateur, pour différents codes et différentes largeurs de la fenêtre de contention,
- la figure 8 représente, pour un code de longueur 255 et un nombre d'utilisateurs égal à 10, le débit global en fonction de la largeur de la fenêtre de contention et de la dimension du code, et
- la figure 9 représente, pour un code de longueur 255 et un nombre d'utilisateurs égal à 10, le débit global en fonction de la largeur de la fenêtre de contention, pour trois valeurs de la dimension du code.

Considérons un ensemble de terminaux d'utilisateurs aptes à transmettre des paquets de données à un certain point d'accès selon un protocole d'accès multiple, tel que le protocole CSMA/CA décrit succinctement ci-dessus. Ces terminaux et ce point d'accès peuvent par exemple appartenir à un réseau sans-fil local (« *Wireless Local Area Network* », ou WLAN en anglais), par exemple de type WiFi.

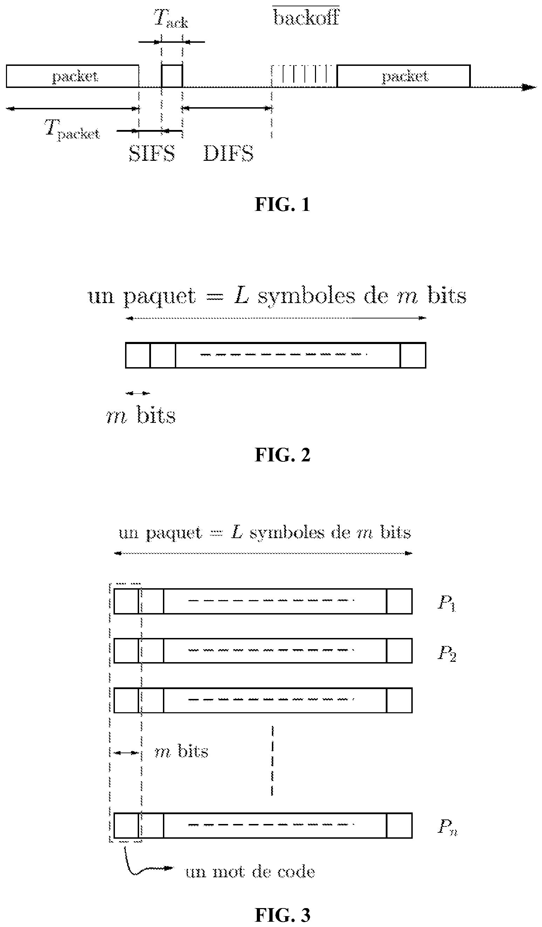

Commençons, en référence à la **figure 1,** par quelques rappels sur les durées mises en jeu, classiquement, dans le protocole CSMA/CA.

Sur la figure 1 :

- $T_{packet}$ est la durée d'émission d'un paquet ;
- SIFS (initiales des mots anglais *«Short InterFrame Space »* signifiant « espace inter-trames court ») est l'intervalle de temps avant qu'une émission soit suivie d'un acquittement (par défaut, le SIFS vaut 10 μs) ;
- $T_{ack}$ est la durée d'un acquittement (par défaut, $T_{ack}$ vaut 2 μs) : si un utilisateur qui a transmis un paquet n'a pas reçu d'acquittement après un intervalle (SIFS+$T_{ack}$), le paquet est considéré comme perdu ;
- DIFS (initiales des mots anglais « *Distributed Interframe Space*» signifiant « espace inter-trame distribué ») est l'intervalle (fixe) de temps, mentionné plus haut, avant lequel un utilisateur qui voit que le canal est inoccupé peut démarrer la durée de contention, mentionnée plus haut (par défaut, DIFS vaut 50 μs) ; et
- la durée de contention : pour éviter que tous les utilisateurs ne se mettent à transmettre à la fin du DIFS, on ajoute cette durée aléatoire, qui est un multiple entier d'un incrément de durée $T_{slot}$ (20 μs par défaut) ; comme expliqué ci-dessus, la durée de contention est déterminée aléatoirement par chaque utilisateur au sein de la fenêtre de contention, notée *W* ci-après, que l'on exprimera en nombre de « slots ».

Selon l'invention, les paquets émis par les utilisateurs sont codés au moyen d'un (ou plusieurs) codes correcteur(s) d'effacements, connus en eux-mêmes. Le code à utiliser est déterminé par le point d'accès en fonction du nombre d'utilisateurs qui communiquent avec lui.

Selon un mode de réalisation, le point d'accès transmet à chaque utilisateur, au moins suite à la connexion de ce terminal au point d'accès, la dimension k du code, ainsi que la largeur *W* de la fenêtre de contention devant être respectée par cet utilisateur, ou seulement la largeur *W* de la fenêtre de contention dans le cas où tous les utilisateurs mettent en œuvre le même code (par exemple, un code dont les paramètres sont normalisés).

Voici donc à présent quelques rappels sur le codage de paquets.

On suppose que tous les paquets émis sont de même taille et contiennent *L* symboles de m bits, comme représenté sur la **figure 2.** Selon un mode de réalisation, l'opération de codage est effectuée transversalement sur un nombre $n$ de paquets successifs $\{P_1, P_2, ..., P_n\}$, de sorte que chacune des $L$ colonnes, contenant $n$ symboles de m bits, forme un mot de code de longueur $n$ et dimension $k$, comme représenté sur la **figure 3.**

Pour $m = 1$, on utilise un code binaire pouvant fonctionner en correction d'effacement ; il suffit pour cela de considérer la matrice de contrôle de parité du code, car chaque équation de parité du code, qui est de la forme :

$$h_1 x_1 + h_2 x_2 + \cdots + h_n x_n = 0, \tag{1}$$

où $h_i \in \{0,1\}$ et $x_i \in \{0,1\}$ pour $i = 1, ..., n$, vaut aussi pour les paquets :

$$h_1 P_1 + h_2 P_2 + \cdots + h_n P_n = \mathbf{0}, \tag{2}$$

où 0 est le paquet dont tous les bits sont à zéro, et l'addition est le XOR des paquets, effectué bit-à-bit.

Pour $m > 1$, on utilise de préférence un code défini sur un corps d'extension $GF(2^m)$, par exemple $CF(2^7)$ ou $CF(2^8)$ selon que $m = 7$ ou $m = 8$. Dans ce cas, l'équation de parité (2) fait intervenir une arithmétique dans ce corps d'extension, en particulier une multiplication. Les codes sont alors des codes de Reed-Solomon (RS). Le décodage de chaque mot de code sur une colonne peut se faire soit sur la base de ces équations de parité, soit par tout autre algorithme de décodage utilisé pour les codes RS (décodage algébrique par exemple).

Les paramètres à prendre en compte pour le choix du code sont notamment les suivants.

Un paramètre important d'un code linéaire, qu'il soit binaire ou non binaire, est le nombre minimal de symboles par lesquels diffèrent deux mots de code différents ; on note $d$ cette quantité, appelée « distance minimale » du code. Les paramètres $n, k, d$ ne sont pas indépendants, mais sont contraints par un certain nombre d'inégalités, dont la borne de Singleton :

$$d \leq n - k + 1. \tag{3}$$

Lorsque l'égalité est atteinte $(d = n - k + 1)$, on dit que le code est Séparable à Distance Maximale (« Maximum Distance Separable », ou MDS, en anglais). Il se trouve que, dans le cas binaire, les seuls codes MDS sont les codes triviaux : code à répétition (un paquet est répété (n - 1) fois), ou un code de parité dans lequel un seul paquet de parité est ajouté à la suite de (n - 1) paquets de données indépendants. Pour avoir des codes non triviaux et plus performants, il faut travailler dans les corps finis mentionnés plus haut ; dans ce cadre, un exemple classique de code MDS est justement celui des codes RS mentionnés plus haut. On mettra donc en œuvre l'invention de préférence au moyen d'un code MDS sur $GF(2^m)$ avec $m > 1$.

Pour l'évaluation des performances, on considère que toutes les configurations d'effacements jusqu'à $(d -1)$ effacements sont corrigées, et que toutes celles de d effacements, ou plus, ne le sont pas (ce qui est pessimiste, car certaines de ces dernières configuration sont corrigées, mais on négligera ce phénomène par la suite). On a donc intérêt à avoir la distance minimale d la plus grande possible pour des valeurs n et $k$ données, d'où l'importance des codes MDS dans cette perspective.

On va décrire à présent un mode de réalisation de l'invention.

Dans ce mode de réalisation, on utilise un code de Reed-Solomon, et, pour des raisons de facilité de mise en œuvre, on choisit de préférence des codes sur $GF(2^8)$ ; les codes peuvent être raccourcis, c'est-à-dire d'une longueur n < 255 octets.

De préférence également, on choisit un rendement $k/n$ adapté au canal tel qu'il est vu par les terminaux. En effet, il serait sous-optimal d'utiliser un code de rendement fixe, car un tel code serait, dans la plupart des cas, soit trop puissant, soit pas assez : si le rendement est trop faible, on introduit de la redondance inutilement et l'on utilise mal le débit disponible ; inversement, si le rendement est élevé, le code est inefficace et n'est pas capable de corriger tous les effacements.

Pour diminuer le taux de perte de paquets, il faut augmenter la largeur $W$ de la fenêtre de contention : les durées de contention (aléatoires) de chaque utilisateur peuvent alors prendre des valeurs plus élevées (donc un intervalle de temps plus grand entre deux transmissions de paquets). Il y a peu de collisions lorsque le nombre d'utilisateurs est petit, car il y a une faible probabilité que deux ou plus tirent la même valeur de durée de contention, le code correcteur est peu efficace, et la baisse du débit global est due principalement au rendement du code correcteur. Au fur et à mesure que le nombre d'utilisateurs augmente, le nombre de collisions que chacun subit augmente aussi, mais, si l'on ne dépasse pas la capacité de correction globale du code, le débit global continuera d'augmenter. Puis, à un certain point, le nombre de collisions commence à dépasser cette capacité de correction ; le codage ne permet alors plus de recouvrer les paquets effacés, et le débit global diminue.

Cette analyse qualitative peut, pour une version légèrement simplifiée du protocole CSMA/CA, être précisée par l'analyse quantitative suivante. On suppose à cet effet que les utilisateurs ont en permanence un paquet à transmettre, de sorte qu'à chaque période de contention tous les utilisateurs tentent d'accéder à la ressource ; le débit global peut ainsi atteindre son maximum théorique (régime saturé, ou « full-buffer » en anglais).

La probabilité qu'un utilisateur *i* donné subisse une collision lors d'une période de contention vaut

$$p_{\mathrm{coll}} = \frac{1}{W} \cdot \tag{4}$$

On peut montrer que la probabilité qu'un utilisateur *i* donné parmi *N* accède au canal parce qu'il a tiré la durée de contention minimale (mais sans garantie d'être le seul, il y a donc possibilité d'une collision), est donnée par

$$p_{\mathrm{access}} = \sum_{k=0}^{W-1} \frac{1}{W} \left(1 - \frac{k}{W}\right)^{N-1} . \tag{5}$$

On en déduit que la probabilité d'effacement vaut

$$p = \frac{1}{\sum_{k=0}^{W-1} \left(1 - \frac{k}{W}\right)^{N-1}} \cdot \tag{6}$$

En l'absence de codage, le débit global pour *N* utilisateurs est donc donné par

$$D_{NC} = N \times p_{\mathrm{win}} / \tau, \tag{7}$$

où $\tau$ est l'intervalle de temps moyen entre deux transmissions, et où

$$p_{\mathrm{win}} = p_{\mathrm{access}} - \frac{1}{W} \tag{8}$$

est la probabilité d'une transmission réussie par l'un quelconque des *N* utilisateurs.

En présence d'un codage de longueur *n*, de dimension *k* et de distance minimale *d*, la capacité maximum de correction du code est de (*d* -1) paquets effacés. La probabilité qu'il y ait au plus (*d* - 1) effacements sur n paquets est donnée par :

$$p_{\mathrm{OK}} = \sum_{k=0}^{d-1} C_n^k \, p^k (1-p)^{n-k}, \tag{9}$$

qui est la probabilité de décodage réussi d'un mot de code de n paquets, dont *k* paquets d'information. Le débit global en présence de codage est donc donné par :

$$D_C = N \times \frac{k}{n} \times p_{\mathrm{acc}} \times p_{\mathrm{OK}} / \tau. \tag{10}$$

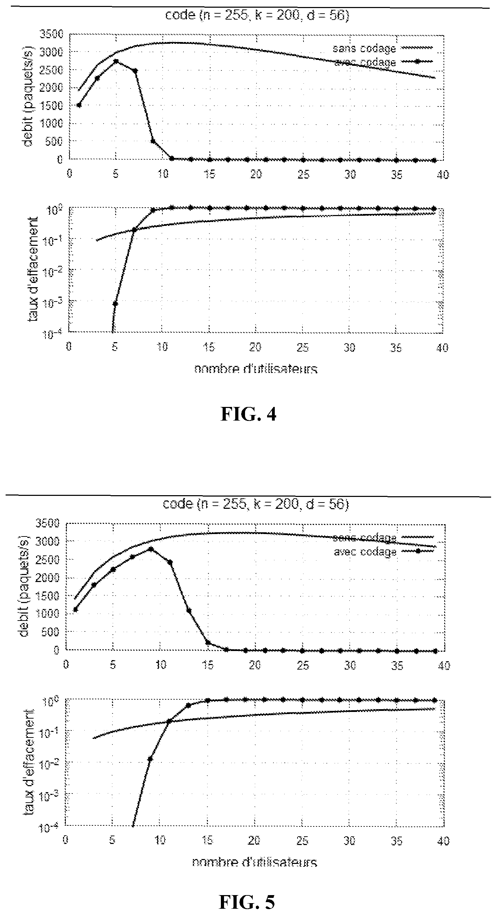

On va illustrer à présent ces résultats au moyen de quelques exemples numériques. Les figures 4 à 7 représentent, pour un nombre d'utilisateurs N variant de 1 à 40 :

- le débit global moyen (exprimé en paquets/s) en l'absence (courbe lisse) et en présence (courbes avec des gros points) d'un codage correcteur, et
- le taux de paquets effacés en l'absence de codage (courbe lisse), et le taux de non-correction après décodage (courbe avec des gros points), par utilisateur.

Selon un premier exemple, illustré sur la **figure 4,** on considère le code ($n$ = 255, $k$ = 200, $d$ = 56), et l'on prend $W$ = 32 slots. On voit sur cette figure que, pour $N$ < 6, le taux d'échec de la correction d'effacements est inférieur à 1% ; on observe seulement la perte de débit occasionnée par le rendement 200/255 du code. Dès que $N \geq 7$, la capacité de correction du code est dépassée, les décodages échouent plus souvent, et le taux d'échec devient supérieur au taux d'effacement en l'absence de codage.

Selon un deuxième exemple, illustré sur la **figure 5,** on utilise le même code, mais avec $W$ = 50 slots. On peut maintenant assurer un taux d'échec inférieur à 1% jusqu'à 9 utilisateurs.

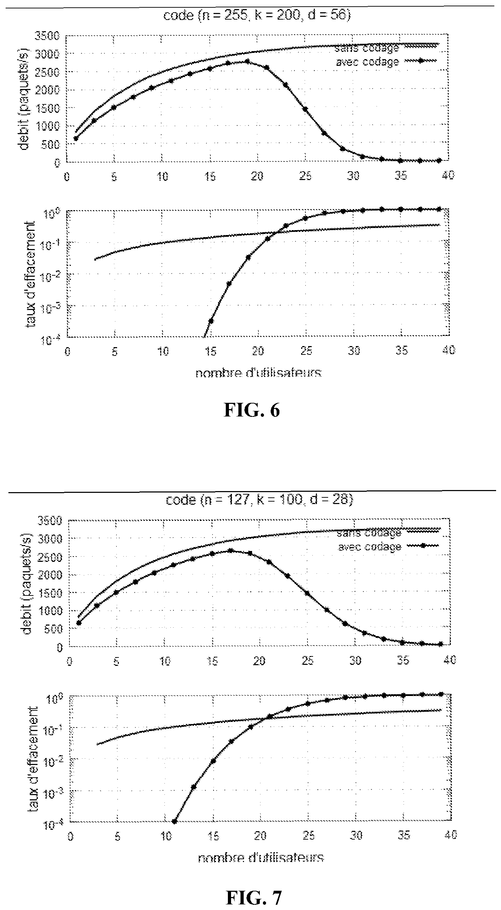

Selon un troisième exemple, illustré sur la **figure 6,** on utilise encore le même code, mais avec $W$ = 100 slots. Cette fois, on peut accepter 17 utilisateurs avec un taux d'échec de 1% après décodage. Pour un faible nombre d'utilisateurs (inférieur à 5), le canal est mal utilisé car la fenêtre de contention est trop grande et le taux de collision dans le canal est inférieur à quelques %. En augmentant le nombre d'utilisateurs, on améliore l'utilisation du canal, et l'on remédie aux collisions supplémentaires grâce au code correcteur. Vers 20 utilisateurs, la capacité de correction du code est dépassée, et le débit global s'effondre.

Selon un quatrième exemple, illustré sur la **figure 7,** on utilise la même fenêtre de contention $W$ = 100 slots que dans l'exemple précédent, mais le code a ici pour paramètres ($n$ = 127, $k$ = 100, $d$ = 28). On observe une très faible dégradation des performances car le code est plus court. Le maximum de débit global est atteint pour environ 17 utilisateurs.

Les résultats ci-dessus suggèrent qu'il est possible de donner une valeur optimale à la largeur de la fenêtre de contention $W$ si, inversement, on suppose connu le nombre d'utilisateurs se disputant l'accès à un même canal. En effet, l'existence d'une largeur optimale de la fenêtre de contention W est le résultat d'un compromis : lorsque la fenêtre est trop réduite, il y a trop de collisions par rapport à la capacité de correction du code, les effacements ne peuvent être récupérés et le débit est nul. Lorsque $W$ augmente, il y a de moins en moins de collisions, le décodage devient efficace. Puis, lorsque $W$ continue d'augmenter, on atteint un stade où il n'y a certes presque plus de collisions, mais où le délai entre deux émissions de paquets devient trop grand (les utilisateurs espacent trop leurs transmissions) et le débit global diminue.

On peut optimiser le débit global en jouant simultanément sur les valeurs de $k$ et $W$ dans le calcul de la fonction $D_c(k,W)$ de l'équation (10), pour un nombre d'utilisateurs $N$ fixé. Pour ce faire, on construit un tableau $D$ dont l'élément $(i,j)$ est égal au débit global $D_C$ lorsque :

- $k = i$, avec $1 \leq i \leq n$, et
- $W = j$, avec $1 \leq j \leq W_{max}$

(où $W_{max}$ est une largeur maximale de la fenêtre de contention, fixée ici arbitrairement à 200 slots), et l'on cherche le couple $(i^*,j^*)$ correspondant au maximum de $D(i,j)$.

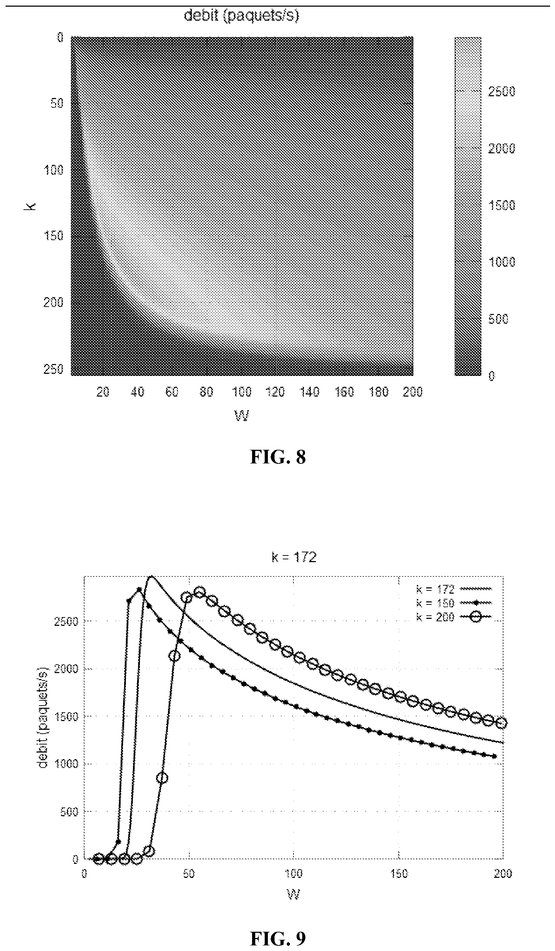

La **figure 8** est un graphique représentatif de $D(k, W)$, pour $N$=10 utilisateurs et un code de longueur $n$ = 255.

La **figure 9** représente, pour $N$=10 utilisateurs et un code de longueur $n$ = 255, le débit global en fonction de la largeur de la fenêtre de contention, pour trois valeurs de la dimension $k$ du code. Autrement dit, la figure 9 correspond à trois sections planes de la figure 8, pour trois valeurs du paramètre $k$ : la valeur optimale ($k$ = 172), et les valeurs $k$ = 150 et $k$ = 200.

On constate que le débit maximum, égal à 2967 paquets/s, est atteint pour $k$ = 172 et une fenêtre de largeur $W$ = 32 slots. Ce débit est supérieur à la valeur indiquée sur la figure 9 pour les deux autres valeurs de $k$ (150, ou 200), valeurs pour lesquelles le maximum est d'ailleurs atteint pour des valeurs différentes du paramètre $W$, tout en étant inférieures audit maximum atteint pour $k$ = 172 et $W$ = 32 slots. Il est donc judicieux de procéder à une optimisation simultanée sur les deux paramètres $k$ et $W$.

On notera pour terminer que l'invention peut être mise en œuvre au sein de nœuds d'un réseau de télécommunications, par exemple des terminaux émetteurs ou des points d'accès d'un réseau sans-fil local, au moyen de composants logiciels et/ou matériels.

Les composants logiciels pourront être intégrés à un programme d'ordinateur classique de gestion de nœud de réseau. C'est pourquoi, comme indiqué ci-dessus, la présente invention concerne également un système informatique. Ce système informatique comporte de manière classique une unité centrale de traitement commandant par des signaux une mémoire, ainsi qu'une unité d'entrée et une unité de sortie. De plus, ce système informatique peut être utilisé pour exécuter un programme d'ordinateur comportant des instructions pour gérer le fonctionnement d'un terminal ou d'un point d'accès selon l'invention.

En effet, l'invention vise aussi un programme d'ordinateur téléchargeable depuis un réseau de communication comprenant des instructions pour gérer le fonctionnement d'un terminal ou d'un point d'accès selon l'invention, lorsqu'il est exécuté sur un ordinateur. Ce programme d'ordinateur peut être stocké sur un support lisible par ordinateur et peut être exécutable par un microprocesseur.

Ce programme peut utiliser n'importe quel langage de programmation, et se présenter sous la forme de code source, code objet, ou de code intermédiaire entre code source et code objet, tel que dans une forme partiellement compilée, ou dans n'importe quelle autre forme souhaitable.

L'invention vise aussi un support d'informations, inamovible, ou partiellement ou totalement amovible, lisible par un ordinateur, et comportant des instructions d'un programme d'ordinateur tel que mentionné ci-dessus. Le support d'informations peut être n'importe quelle entité ou dispositif capable de stocker le programme. Par exemple, le support peut comprendre un moyen de stockage, tel qu'une ROM, par exemple un CD ROM ou une ROM de circuit microélectronique, ou un moyen d'enregistrement magnétique, tel qu'un disque dur, ou encore une clé USB (« *USB flash drive* » en anglais).

D'autre part, le support d'informations peut être un support transmissible tel qu'un signal électrique ou optique, qui peut être acheminé via un câble électrique ou optique, par radio ou par d'autres moyens. Le programme d'ordinateur selon l'invention peut être en particulier téléchargé sur un réseau de type Internet.

En variante, le support d'informations peut être un circuit intégré dans lequel le programme est incorporé, le circuit étant adapté pour exécuter ou pour être utilisé dans la gestion d'un terminal ou d'un point d'accès selon l'invention.

## Revendications

1. Point d'accès comprenant des moyens pour recevoir des paquets de données émis par au moins un terminal conformément à un protocole d'accès multiple à détection de porteuse, ainsi que des moyens pour transmettre audit terminal au moins la largeur de la fenêtre de contention (W) que ledit terminal doit observer pour l'émission d'un paquet, **caractérisé en ce que**, lesdits paquets émis étant codés par ledit au moins un terminal au moyen d'un code correcteur d'effacements de dimension k, de longueur n et de distance minimale d, chaque opération de codage étant appliquée sur n paquets successifs ($P_1,...,P_n$), ladite largeur de la fenêtre de contention (W) transmise par le point d'accès audit terminal est fonction au moins de la distance minimale d dudit code correcteur d'effacements et du nombre total de terminaux connectés audit point d'accès, et ledit point d'accès comprend en outre des moyens pour décoder les paquets reçus codés au moyen dudit code correcteur d'effacements et corriger au moins toutes les configurations de paquets effacés jusqu'à d-1 paquets effacés.

2. Point d'accès selon la revendication 1, **caractérisé en ce qu'**il possède en outre des moyens pour transmettre audit terminal au moins un paramètre (k) dudit code correcteur d'effacements.

3. Système de transmission de paquets de données, **caractérisé en ce qu'**il comprend au moins un point d'accès selon la revendication 1 ou 2, et au moins un terminal comprenant des moyens pour transmettre au point d'accès des paquets de données émis conformément audit protocole d'accès multiple à détection de porteuse, ainsi que des moyens pour recevoir de la part dudit point d'accès, et prendre en compte, au moins la largeur de la fenêtre de contention (W) que ledit terminal doit observer pour l'émission d'un paquet, lesdits paquets émis étant codés par le terminal au moyen dudit code correcteur d'effacements de dimension k, de longueur n et de distance minimale d, chaque opération de codage étant appliquée sur n paquets successifs ($P_1,...,P_n$), ledit code correcteur d'effacements permettant de corriger au moins toutes les configurations de paquets effacés jusqu'à d-1 paquets effacés.

4. Système selon la revendication 4 dans lequel ledit terminal comprend en outre des moyens pour recevoir de la part dudit point d'accès, et prendre en compte, au moins le paramètre k dudit code correcteur d'effacements.

5. Moyen de stockage de données inamovible, ou partiellement ou totalement amovible, **caractérisé en ce qu'**il comporte des instructions d'un programme d'ordinateur pour gérer le fonctionnement d'un point d'accès selon la revendication 1 ou 2 lorsqu'il est exécuté par un ordinateur ou un microprocesseur dudit point d'accès, les instructions permettant de configurer les moyens dudit point d'accès avec les caractéristiques correspondantes audit fonctionnement.

6. Programme d'ordinateur téléchargeable comprenant des instructions pour gérer le fonctionnement d'un point d'accès selon la revendication 1 ou 2 lorsqu'il est exécuté sur un ordinateur ou un microprocesseur dudit point d'accès, les instructions permettant de configurer les moyens dudit point d'accès avec les caractéristiques correspondantes audit fonctionnement.

7. Procédé de communication conformément à un protocole d'accès multiple à détection de porteuse comprenant :

une étape d'émission de paquets de données par au moins un terminal selon ledit protocole d'accès multiple à détection de porteuse, lesdits paquets de données étant codés par ledit terminal au moyen d'un code correcteur d'effacements de dimension k, de longueur n et de distance minimale d, chaque opération de codage étant appliquée sur n paquets successifs ($P_1$,...,$P_n$) ; et

une étape de transmission par un point d'accès audit terminal de la largeur de la fenêtre de contention (W) que ledit terminal doit observer pour l'émission d'un paquet lors de ladite étape d'émission, ladite largeur de la fenêtre de contention étant fonction au moins de la distance minimale d dudit code correcteur d'effacements et du nombre total de terminaux connectés audit point d'accès.

**Patentansprüche**

1. Zugangspunkt umfassend Mittel zum Empfangen der Datenpakete, die von mindestens einem Endgerät entsprechend einem Protokoll für Mehrfachzugriff mit Trägerprüfung gesendet werden, sowie Mittel zum Übertragen zumindest der Breite des Wettbewerbsfensters (W), welches das Endgerät zum Senden eines Pakets beachten muss, **dadurch gekennzeichnet, dass**, wobei die gesendeten Pakete von dem mindestens einen Endgerät mittels eines Löschungskorrekturcodes einer Dimension k, einer Länge n und eines Mindestabstands d codiert werden, wobei jede Codierungsoperation auf n aufeinanderfolgende Pakete ($P_1$,...,$P_n$) angewandt wird, die Breite des Wettbewerbsfensters (W), das vom Zugangspunkt an das Endgerät übertragen wird, zumindest vom Mindestabstand d des Löschungskorrekturcodes und von der Gesamtzahl von Endgeräten, die mit dem Zugangspunkt verbunden sind, abhängig ist, und der Zugangspunkt ferner Mittel zum Decodieren der empfangenen Pakete, die mittels des Löschungskorrekturcodes codiert sind, und Korrigieren zumindest aller Konfigurationen gelöschter Pakete bis d-1 gelöschte Pakete umfasst.

2. Zugangspunkt nach Anspruch 1, **dadurch gekennzeichnet, dass** er ferner Mittel zum Übertragen mindestens eines Parameters (k) des Löschungskorrekturcodes an das Endgerät aufweist.

3. System zur Übertragung von Datenpaketen, **dadurch gekennzeichnet, dass** es mindestens einen Zugangspunkt nach Anspruch 1 oder 2 umfasst, und mindestens ein Endgerät umfassend Mittel zum Übertragen der Datenpakete, die gemäß dem Protokoll für Mehrfachzugriff mit Trägerprüfung gesendet werden, an den Zugangspunkt, sowie Mittel zum Empfangen, von dem Zugangspunkt, und zum Berücksichtigen, zumindest der Breite des Wettbewerbsfensters (W), welches das Endgerät zum Senden eines Pakets beachten soll, wobei die gesendeten Pakete von dem Endgerät mittels des Löschungskorrekturcodes einer Dimension k, einer Länge n und eines Mindestabstands d codiert werden, wobei jede Codierungsoperation auf n aufeinanderfolgende Pakete ($P_1$, ... ,$P_n$) angewandt wird, wobei es der Löschungskorrekturcode gestattet, zumindest alle Konfigurationen gelöschter Pakete bis d-1 gelöschte Pakete zu korrigieren.

4. System nach Anspruch 4, wobei das Endgerät ferner Mittel zum Empfangen, von dem Zugangspunkt, und zum Berücksichtigen, zumindest des Parameters des Löschungskorrekturcodes umfasst.

5. Nicht entfernbares oder teilweise oder vollständig entfernbares Datenspeichermittel, **dadurch gekennzeichnet, dass** es Anweisungen eines Computerprogramms zur Verwaltung des Betriebs eines Zugangspunkts nach Anspruch 1 oder 2, wenn es von einem Computer oder einem Mikroprozessor des Zugangspunkts ausgeführt wird, umfasst, wobei es die Anweisungen gestatten, die Mittel des Zugangspunkts mit den Merkmalen, die dem Betrieb entsprechen, zu konfigurieren.

6. Herunterladbares Computerprogramm umfassend Anweisungen zur Verwaltung des Betriebs eines Zugangspunkts nach Anspruch 1 oder 2, wenn es auf einem Computer oder einem Mikroprozessor des Zugangspunkts ausgeführt wird, wobei es die Anweisungen gestatten, die Mittel des Zugangspunkts mit den Merkmalen, die dem Betrieb entsprechen, zu konfigurieren.

7. Verfahren zur Kommunikation entsprechend einem Protokoll für Mehrfachzugriff mit Trägerprüfung, umfassend:

einen Schritt des Sendens von Datenpaketen von mindestens einem Endgerät gemäß dem Protokoll für Mehrfachzugriff mit Trägerprüfung, wobei die Datenpakete vom Endgerät mittels eines Löschungskorrekturcodes einer Dimension k, einer Länge n und eines Mindestabstands d codiert werden, wobei jede Codierungsoperation auf n aufeinanderfolgende Pakete ($P_1$,...,$P_n$) angewandt wird; und
einen Schritt des Übertragens der Breite des Wettbewerbsfensters (W), welches das Endgerät zum Senden eines Pakets beim Schritt des Sendens beachten muss, von einem Zugangspunkt an das Endgerät, wobei die Breite des Wettbewerbsfensters von zumindest dem Mindestabstand d des Löschungskorrekturcodes und der Gesamtzahl von Endgeräten, die mit dem Zugangspunkt verbunden sind, abhängig ist.

**Claims**

1. Access point comprising means for receiving data packets sent by at least one terminal using a carrier-sense-multiple-access protocol, and means for transmitting, to said terminal, at least the width (W) of the backoff window that said terminal must observe when sending a packet, **characterized in that**, said sent packets being coded by said at least one terminal by means of an erasure-correcting code of dimension k, of length n and of minimum distance d, each coding operation being applied to n successive packets ($P_1$,...,$P_n$), said width (W) of the backoff window transmitted by the access point to said terminal is dependent at least on the minimum distance d of said erasure-correcting code and on the total number of terminals connected to said access point, and said access point furthermore comprises means for decoding the received packets coded by means of said erasure-correcting code and for correcting at least all the configurations of erased packets up to d-1 erased packets.

2. Access point according to Claim 1, **characterized in that** it furthermore possesses means for transmitting, to said terminal, at least one parameter (k) of said erasure-correcting code.

3. System for transmitting data packets, **characterized in that** it comprises at least one access point according to Claim 1 or 2, and at least one terminal comprising means for transmitting, to the access point, data packets sent using said carrier-sense-multiple-access protocol, and means for receiving, from said access point, and taking into account, at least the width (W) of the backoff window that said terminal must observe when sending a packet, said sent packets being coded by the terminal by means of said erasure-correcting code of dimension k, of length n and of minimum distance d, each coding operation being applied to n successive packets ($P_1$,...,$P_n$), said erasure-correcting code allowing at least all the configurations of erased packets up to d-1 erased packets to be corrected.

4. System according to Claim 4, wherein said terminal furthermore comprises means for receiving, from said access point, and taking into account, at least the parameter (k) of said erasure-correcting code.

5. Unremovable, or partially or completely removable, data-storing means, **characterized in that** it contains instructions of a computer program for managing the operation of an access point according to Claim 1 or 2 when it is executed by a computer or a microprocessor of said access point, the instructions allowing the means of said access point to be configured with the characteristics corresponding to said operation.

6. Downloadable computer program containing instructions for managing the operation of an access point according to Claim 1 or 2 when it is executed on a computer or a microprocessor of said access point, the instructions allowing the means of said access point to be configured with the characteristics corresponding to said operation.

7. Method for achieving communication using a carrier-sense-multiple-access protocol, comprising:

   a step in which data packets are sent by at least one terminal using said carrier-sense-multiple-access protocol, said data packets being coded by said terminal by means of an erasure-correcting code of dimension k, of length n and of minimum distance d, each coding operation being applied to n successive packets ($P_1$,...,$P_n$) ; and
   a step in which the width (W) of the backoff window that said terminal must observe when sending a packet in said sending step is transmitted by an access point to said terminal, said width of the backoff window being dependent at least on the minimum distance d of said erasure-correcting code and on the total number of terminals connected to said access point.

$T_{ack}$

$\overline{backoff}$

packet

packet

$T_{packet}$

SIFS    DIFS

**FIG. 1**

un paquet $= L$ symboles de $m$ bits

$m$ bits

**FIG. 2**

un paquet $= L$ symboles de $m$ bits

$P_1$

$P_2$

$m$ bits

$P_n$

un mot de code

**FIG. 3**

**FIG. 4**

**FIG. 5**

code (n = 255, k = 200, d = 56)

**FIG. 6**

code (n = 127, k = 100, d = 28)

**FIG. 7**

**FIG. 8**

**FIG. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070223434 A
- US 2010103913 A

**Littérature non-brevet citée dans la description**

- *Time-Division Multiple Access*
- **G. LIVA ; E. PAOLINI ; M. CHIANI.** High-Throughput Random Access via Codes on Graphs. *FUNEMS,* 2010
- Distributed Coordination Function. *Fonction de Co-ordination Distribuée*
- Media Access Control. *Contrôle d'Accès au Support*
- Carrier Sense Multiple Access/Collision Avoidance. *Accès Multiple à Détection de Porteuse/Evitement de Collisions*
- *Maximum Distance Separable*